# EUROPEAN PATENT APPLICATION

(11) **EP 0 572 348 A1**
(43) Date of publication of application: **01.12.1993**
(21) Application number: 93610030.4
(22) Date of filing: 11.05.1993
(51) Int. Cl.: G03B 27/32, G03F 7/20

(54) **Apparatus for exposing and developing light-sensitive material**

(30) Priority: 26.05.1992 DK 695/92
(71) Applicant: ESKOFOT, DK-2750 Ballerup (DK)
(72) Inventor: Juel Nielsen, Steen, DK-2750 Ballerup (DK)
(74) Representative: Siiger, Joergen

(57) **Abstract**

An apparatus for exposing and developing a sheet of light-sensitive material, said apparatus comprising an optical image-producing system consisting of an original plane (10), an objective plane (8), and an image plane (6), and a developing station (18, 20), whereby the sheet of light-sensitive material can be advanced after the exposure in the image plane (6) to the developing station (18, 20) so as to be developed. The apparatus comprises further an image-setter (22, 22') placed adjacent, preferably below the image plane of the optical image-producing system, and guiding means (24) for advancing the material exposed by the image-setter to the developing station (18, 20). The image-setter can be placed in the usually unutilized cavity below the optical system. In addition, the apparatus allows several possibilities of use. It turned out that the same developing station can be used. The image-setter can optionally be adapted to expose selected portions of the light-sensitive material, which can subsequently be exposed by means of the optical image-producing system. In this manner some portions of a sheet of light-sensitive material are exposed by means of the image-setter, whereas other portions of said material can be exposed by means of the optical image-producing system. As a result, the apparatus is more universal than previously known.

## Description

The invention relates to an apparatus for exposing and developing a sheet of light-sensitive material, said apparatus comprising an optical image-producing system consisting of an original plane, an objective plane, and an optionally inclining image plane, and a developing station preferably arranged close to the image plane, whereby the sheet of light-sensitive material can be advanced after the exposure in the image plane to the developing station so as to be developed.

An apparatus of this type is manufactured by the Applicant and is sold under the Trade name Eskofot 1640. The original table is formed by a horizontal surface placed for ergonomical reasons at a suitable height above the floor. The path of the light rays from the original table is deflected by means of an inclined mirror above the original table, whereafter the light rays are transmitted through an objective to the image plane in a lightproof chamber behind a lightproof bellows. The deflecting mirror serves to reverse the image. Feeding rollers behind the image plane advance the light-sensitive material to the image plane. After the exposure, the light-sensitive material is advanced to a developing station placed below the original table. This apparatus is, however, encumbered with the drawback that the volume is not completely utilized .

The object of the invention is to provide an apparatus of the above type which is more universal compared to previous apparatuses without requiring more room.

The apparatus according to the invention is characterised in that it further comprises an image-setter (a high-resoluble photographic laser printer) placed adjacent, preferably below the image plane of the optical image-producing system, and guiding means for advancing the light-sensitive material exposed by the image-setter to the developing station. In this manner the image-setter can be placed in the otherwise unutilized cavity optionally found below the optical system. It turned out that it is possible to use the same developing station for light-sensitive material exposed by means of the optical image-producing system as well as for light-sensitive material exposed by means of the image-setter. As a result the apparatus can be used for several purposes without requiring more room than previously known.

Moreover according to the invention the means for advancing the material exposed by means of the image-setter to the developing station may be formed by a guide chute.

In addition according to the invention the guide chute may be provided with one or several pairs of squeezing rollers for the advancing of the sheets of light-sensitive material exposed by means of the image-setter.

The image-setter may alternatively according to the invention be placed above the optical image-producing system and optionally be adapted to expose the light-sensitive material to be exposed by means of the optical image-producing system. As a result, an integrated process can be performed.

Finally according to the invention the image-setter may be adapted to expose selected portions of the light-sensitive material to be exposed by means of the optical image-producing system. In this manner some portions of a sheet of light-sensitive material can be exposed by means of the image-setter, whereas other portions of said material can be exposed by means of the optical image-producing system. As a result, the apparatus is more universal than previously known.

The invention is described in greater detail below with reference to the accompanying drawings, in which
Figure 1 illustrates an apparatus according to the invention for exposing a sheet of light-sensitive material by means of an optical image-producing system and/or and image-setter,
Figure 2 illustrates a portion of the apparatus of Figure 1 on a larger scale,
Figure 3 illustrates a corresponding apparatus for exposing sheets larger than the sheet of Figure 1,
Figure 4 is a sectional view of the apparatus of Figure 3,
Figure 5 illustrates a local network including the apparatuses of Figures 1 and 3.

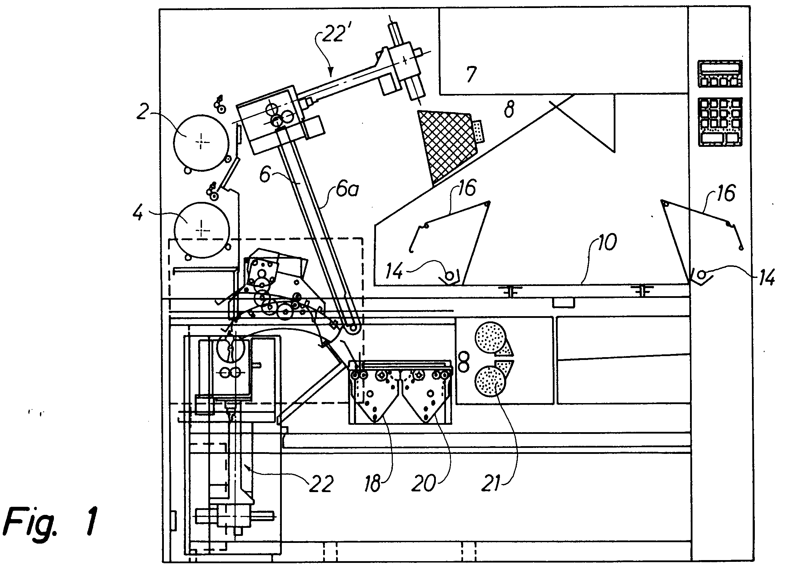

The apparatus of Figure 1 is to be used for exposing sheets of light-sensitive material, such as offset plates. The light-sensitive material is fed from some feed rollers 2, 4, and after cutting off by means of some knives not shown the material is advanced to the image plane 6 of an optical image-producing system in addition including an original plane 10 and an objective plane 8. The feed rollers 2, 4 are to be used for light-sensitive material of various widths and for various types, such as paper or polyester. When the light-sensitive material has been advanced to the image plane of the optical image-producing system, it is fixed to a carrying plate 6 by way of sucking through openings in said plate. The carrying plate 6 is slightly inclined and placed in a lightproof chamber behind a lightproof bellows 7 supporting an objective 8. The light-sensitive material on the carrying plate 6 is exposed through the objective 8, an inclined mirror 12 being arranged in front of the objective 8. The inclining mirror 12 deflects the light from a horizontal original table 10 placed therebelow and on which an original can be placed. The original is exposed by means of elongated exposure means 14 along the sides of the original table 10. These exposure means 14 expose the original through some reflectors 16 reflecting the light downwards towards the original table 10. If desired, exposure means can also be provided below the original table 10. After the exposure, the light-sensitive material is advanced by means of perforated conveyor belts 6a at the carrying plate 6 downwards to a developing station placed below the original table 10. The developing station comprises a developing bath 18 and a fixing bath 20. A buffer spring in connection with the developing bath 18 ensures the correct introduction into the developing bath 18. Each bath 18, 20 includes rollers for guiding the advancing of the sheets through said baths 18, 20. After the fixing bath 20, an air-drying unit in form of a hot-air blower 21 is provided. An output tray is provided after the blower 21.

An image-setter, viz. a high-resoluble photographic laser printer 22, such as of the type ULTRE, is placed below the inclined carrying plate 6. The image-setter 22 is of a height of about 60 cm and fits exactly in the otherwise unutilized cavity below the inclined carrying plate 6 and the feed rollers 2, 4. The image-setter 22 comprises a hollow, fan-shaped, funnel-shaped and lightproof body. A rotatable polygonal mirror is placed at the pointed end of the funnel-shaped body, said mirror being supplied with a light beam from a light-emitting light diode, whereby said mirror can deflect said light beam so as to provide a scanning light beam from a slot at the upper expanded end of the funnel-shaped body. A scanning is performed over a length of about 310 mm or 400 mm in response to the type of image-setter. The diameter of the scanning light beam, i.e. the diameter of the light spot, is about 1/50 mm. This light beam is modulated in response to the signal to be emitted, the light-emitting diode being turned on and off in response to a modulation signal from an RIP 50, said signal being transmitted to a modulator in connection with the diode through a local network.

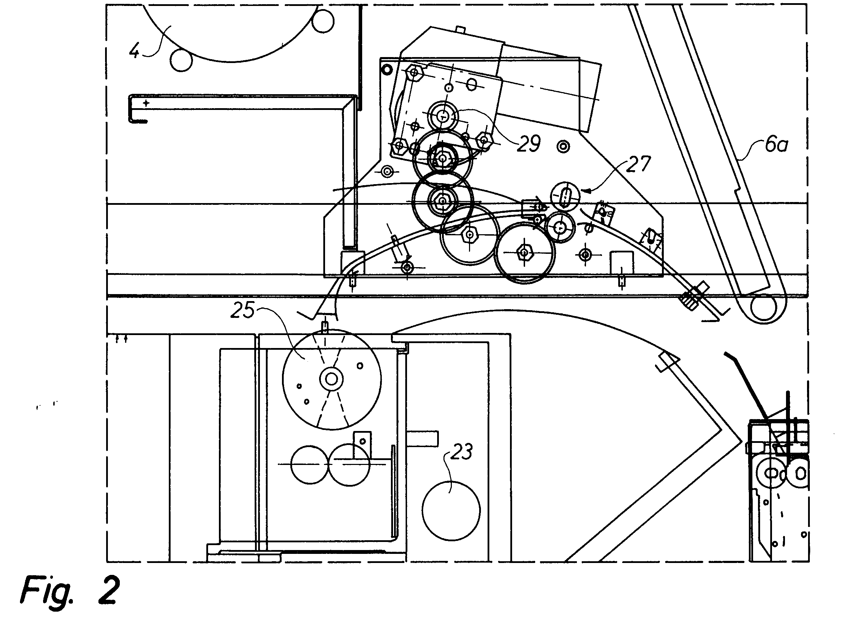

A sheet of light-sensitive material from a feed roller 23 is advanced as shown in Figure 2 past the slot of the funnel-shaped body of the image-setter 22. The sheet of light-sensitive material is thereby exposed by the scanning light beam from the image-setter 22. The feed roller 23 is associated with a lightproof lid 19 which can be tilted outwards. Then the sheet of light-sensitive material is advanced through some rollers and a cutting device 25 to feed means in form of a superposed feed chute 24. One or several pairs 27 of squeezing rollers are arranged at the feed chute 24 and advance the light-sensitive material to the developing station 18, 20. The emulsion of the light-sensitive material faces downwards during the exposure and upwards during the developing in the developing station 18. 20. The pairs 27 of squeezing rollers are driven by means of a driving motor 29 with a gear box. The light-sensitive material is typically silver-based, preferably of the type Mitsubishi Silver Master Digiplate (SDP) or AGFA Supermaster (SET) and can use the same developing station as the light-sensitive material for the optical image-producing system with corresponding Mitsubishi-plates (SLM or SLP) and AGFA-plates SPP-UT or SFP-OP, respectively. However, it is also possible to use photoconductive light-sensitive material in connection with an electrostatic process.

As an alternative, the image-setter can be placed above the optical image-producing system at 22' in Figure 1 and be adapted to expose selected portions of the light-sensitive material, other portions of said light-sensitive material then being exposed by means of the optical image-producing system. After the exposure by means of the optical image-producing system, the light-sensitive material is advanced downwards to the developing station 18, 20, whereby an integrated image-production can be carried out. The light-sensitive material is preferably of the type Digitale which is sensitive to the wavelength of the laser light and to the light spectrum of light source of the optical system.

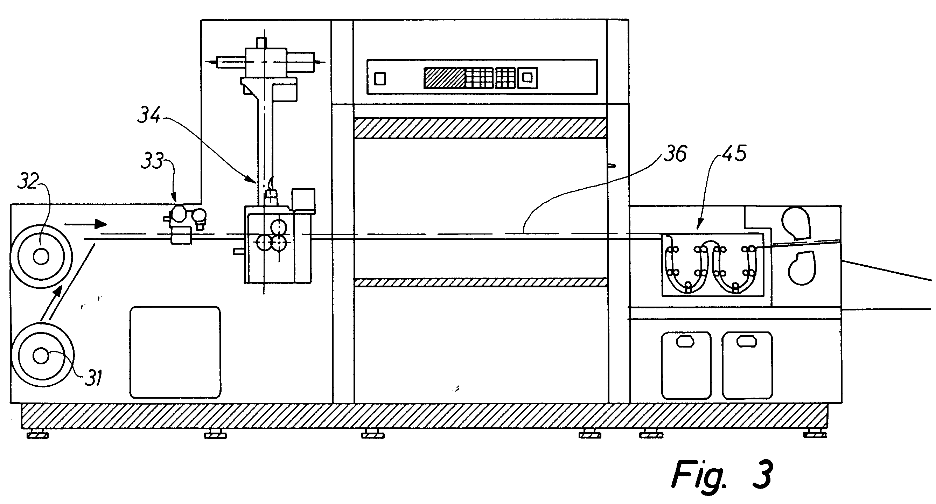

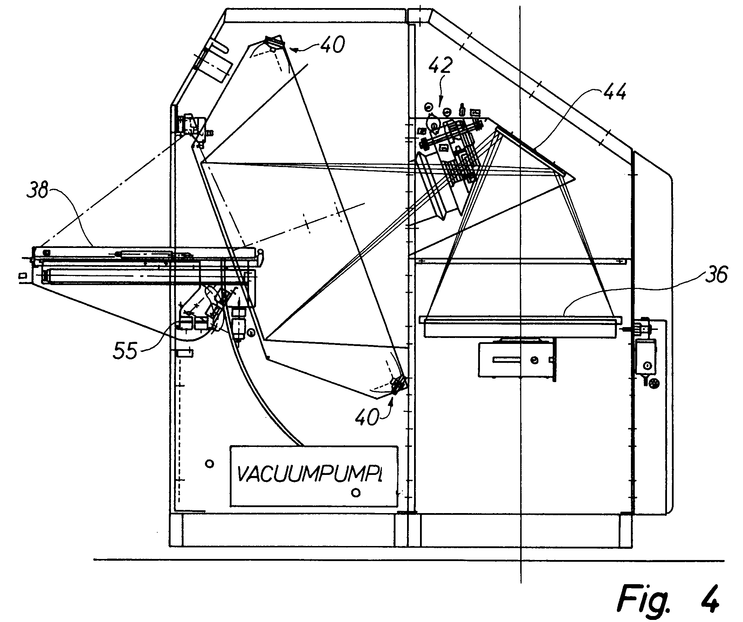

Figure 3 illustrates a corresponding apparatus for exposing sheets larger than the above sheets. One of the feed rollers 31, 32 to the left in the Figure advances light-sensitive material along a horizontal path to a cutting device 33 and then to an image-setter 34 placed above the advancing path. The image-setter 34 comprises some rollers serving to determine the position of the light-sensitive material. From the image-setter 34, the light-sensitive material is advanced to the image plane 36 of an optical image-producing system. In this case too, the image-setter 34 receives a modulation signal from RIP 50 through the local network. Figure 4 is a sectional view through the optical image-producing system in the apparatus. An original table 38 to the left may be tilted into a horizontal position for the insertion of an original. The original is retained by means of a superposed glass plate. After the insertion of the original, the original table 38 is tilted about an axis of rotation 55 into an inclined position forming an angle of about 70° with horizontal. In this position the original is exposed by means of exposure means 40 at the top and at the bottom, respectively. The exposure means 40 are provided with reflectors. The light from the exposed original is transmitted through an objective 42 to an inclined deflecting mirror 40, and after the deflection and reversion by means of the mirror 44 the light is transmitted downwards towards the horizontal image plane 36 therebelow for the exposure of the light-sensitive material advanced to the image plane. After the exposure, the light-sensitive material is advanced to a developing station 45 to the right in Figure 3. After the developing, the fixing, and the rinsing, the material is advanced to an air-drying unit.

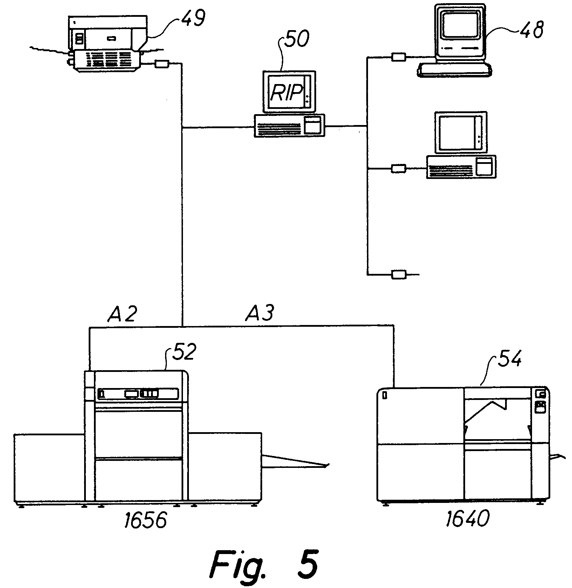

Figure 5 illustrates the local network connecting the exposure apparatuses 52, 54 to RIP 50. RIP 50 has typically a resolution of 1,200 to 3,000 dpi and is a unit converting standard codes for text and graphics into turning on/off signals for a modulator of the light-emitting diode in such a manner that the text and the graphics are digitized by means of micropixels corresponding to the resolution of the image-setter in question. Correspondingly, the pixel data containing the grey-tone value of an image element are converted into turning on/off signals for the modulator so that the raster spot size corresponding to the grey-tone value of the image element is digitized by means of the micropixels of the image-setter.

The network can be connected to one or several personal computers 48 with a keyboard. The network can furthermore be connected to a coarse-resoluble control printer, viz. a laser printer, for plain paper with a resolution of 300 dpi. RIP 50 is a Raster Image Processor and is in fact a program encoded in a computer and is for instance of the type PostScript sold by the companies Hyphen or Birmy Graphics.

Each exposure apparatus is provided with a keyboard for the setting of the magnifying degree, the exposure period, the developing temperature, developing speed etc.

## Claims

1. An apparatus for exposing and developing a sheet of light-sensitive material, said apparatus comprising an optical image-producing system consisting of an original plane (10), an objective plane (8), and an optionally inclining image plane (6), and a developing station (18, 20) preferably arranged close to the image plane (6), whereby the sheet of light-sensitive material can be advanced after the exposure in the image plane (6) to the developing station (18, 20) so as to be developed, characterised in that it further comprises an image-setter (a high-resoluble photographic laser printer) (22, 22') placed adjacent, preferably below the image plane of the optical image-producing system (6, 8, 10), and guiding means for advancing the light-sensitive material exposed by the image-setter (22, 22') to the developing station (18, 20).

2. An apparatus as claimed in claim 1, characterised in that the guiding means advancing the material exposed by image-setter (22) to the developing station (18, 20) are formed by a guide chute (24).

3. An apparatus as claimed in claim 2, characterised in that the guide chute (24) is provided with one or more pairs of squeezing rollers for the advancing of the sheet of light-sensitive material exposed by the image-setter (22).

4. An apparatus as claimed in claim 1, characterised in that the image-setter (22') has been arranged above the optical image-producing system (6, 8, 10) and is optionally adapted to expose the light-sensitive material to be exposed by means of the optical image-producing system (6, 8, 10).

5. An apparatus as claimed in claim 4, characterised in that the image-setter (22') is adapted to expose selected portions of the light-sensitive material to be exposed by means of the optical image-producing system (6, 8, 10).
